(19) **Europäisches Patentamt / European Patent Office / Office européen des brevets**

(11) **EP 2 978 127 B1**

(12) **FASCICULE DE BREVET EUROPEEN**

(45) Date de publication et mention
de la délivrance du brevet:
**16.01.2019 Bulletin 2019/03**

(51) Int Cl.:
*H03G 3/30* (2006.01)     *H03F 1/30* (2006.01)
*H03F 3/189* (2006.01)     *H03F 3/24* (2006.01)
*H03K 5/01* (2006.01)

(21) Numéro de dépôt: **15176932.0**

(22) Date de dépôt: **15.07.2015**

(54) **PROCÉDÉ DE COMPENSATION NUMÉRIQUE DES VARIATIONS, EN FONCTION DE LA TEMPÉRATURE, D'UNE GRANDEUR ÉLECTRIQUE D'UN ÉQUIPEMENT DE TÉLÉCOMMUNICATIONS RADIOFRÉQUENCE SPATIAL EMBARQUÉ**

**VERFAHREN ZUR DIGITALEN KOMPENSATION VON VARIATIONEN, ABHÄNGIG VON DER TEMPERATUR, EINER ELEKTRISCHEN GRÖSSE EINER INTEGRIERTEN WELTRAUM-FUNKTELEKOMMUNIKATIONSAUSRÜSTUNG**

**METHOD FOR DIGITALLY COMPENSATING VARIATIONS, BASED ON THE TEMPERATURE, OF AN ELECTRICAL VARIABLE OF AN ONBOARD SPATIAL RADIO FREQUENCY TELECOMMUNICATIONS DEVICE**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **18.07.2014 FR 1401615**

(43) Date de publication de la demande:
**27.01.2016 Bulletin 2016/04**

(73) Titulaires:
• **THALES**
  **92400 Courbevoie (FR)**
• **Centre National d'Etudes Spatiales**
  **75039 Paris Cedex 01 (FR)**

(72) Inventeurs:
• **Maynard, Jean**
  **31520 Ramonville (FR)**
• **Rodriguez, Raoul**
  **31150 Bruguières (FR)**
• **Mouchon, Grégory**
  **31037 Toulouse Cedex 1 (FR)**
• **Chabbert, Philippe**
  **31037 Toulouse Cedex 1 (FR)**

(74) Mandataire: **Esselin, Sophie et al
Marks & Clerk France
Conseils en Propriété Industrielle
Immeuble Visium
22 avenue Aristide Briand
94117 Arcueil Cedex (FR)**

(56) Documents cités:
**WO-A1-2012/114836      US-A1- 2004 213 355
US-A1- 2005 221 764      US-A1- 2006 267 703
US-B1- 6 553 084**

EP 2 978 127 B1

**Description**

La présente invention concerne un procédé de compensation numérique des variations, en fonction de la température, d'une grandeur électrique d'un équipement de télécommunications radiofréquence spatial embarqué. Elle s'applique à tout équipement de télécommunications utilisant une commande numérique et dont une grandeur électrique varie en fonction de la température. La grandeur électrique qui varie peut être de tout type, par exemple un gain, ou une tension, ou une phase, ou une puissance, ou une fréquence, ou d'un autre type. La commande numérique peut être de tous types, par exemple, une tension de commande de gain fixe ou un contrôle de phase ou de puissance ou de fréquence, ou une tension de commande de dispositif de linéarisation à pré-distorsion, ou d'autre type. En particulier, elle s'applique dans le domaine des applications spatiales, aux équipements électroniques de télécommunications radiofréquence utilisant des commandes numériques tels que les équipements intégrés dans des chaînes radiofréquence à bord des satellites de télécommunications, comme par exemple les amplificateurs à faible bruit, les pré-amplificateurs, les amplificateurs de puissance à état solide, les atténuateurs de gain ou les convertisseurs de fréquence, les déphaseurs.

Pour la bonne compréhension de l'invention, la suite de la description est relative à l'exemple précis d'un équipement dont la grandeur électrique qui varie en fonction de la température est le gain ou la phase de l'équipement et où la commande numérique est une tension de commande mais il est bien entendu que l'invention n'est pas limitée à cette grandeur électrique et à ce type de commande.

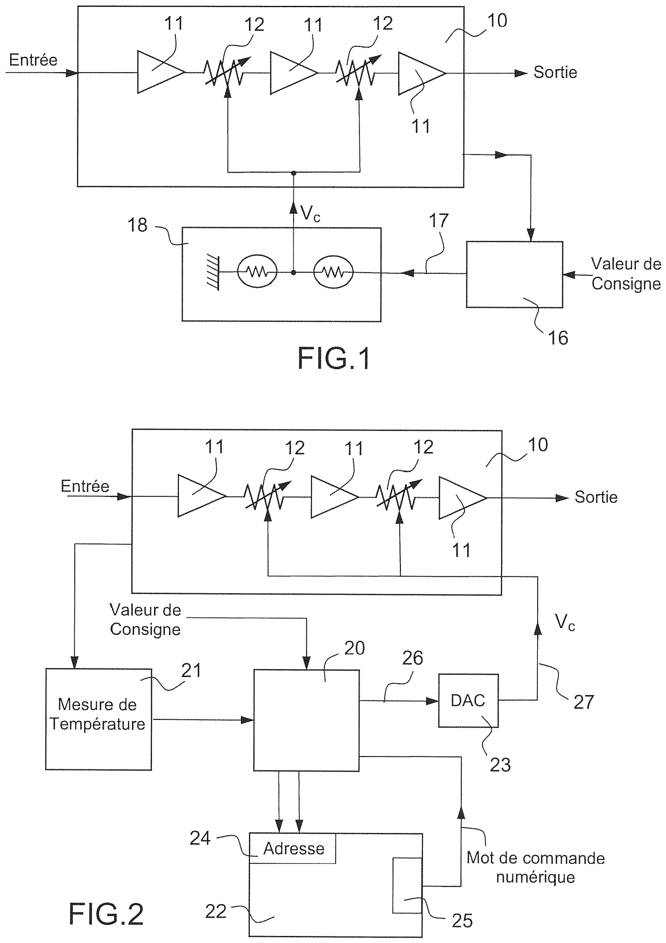

Comme représenté sur l'exemple de la figure 1, la compensation des variations d'une grandeur électrique d'un équipement radiofréquence 10 en fonction de la température, par exemple les variations du gain ou de la phase d'une chaîne radiofréquence comportant, reliés en série, des amplificateurs 11 et des atténuateurs 12 pouvant être commandés, par exemple en tension, est classiquement réalisée à partir d'une seule commande Vc analogique appliquée en entrée de l'équipement. Pour cela, à partir d'une consigne, par exemple de gain, imposée par un utilisateur, un dispositif de commande 16 élabore une commande analogique 17 qui est appliquée à l'équipement 10 par l'intermédiaire d'un circuit électronique à base de résistances et de thermistances 18, les thermistances assurant la compensation en température de l'équipement. La compensation des variations, par exemple du gain, d'un équipement par commande analogique nécessite donc d'ajouter des câblages de résistances et de thermistances directement sur l'équipement 10, ce qui augmente la masse, l'encombrement et le coût de l'équipement. De plus, la valeur de ces composants doit être optimisée finement et nécessite d'utiliser des procédés lourds impliquant des cycles en température pour déterminer les valeurs des composants, vérifier les performances et réitérer ces cycles en température et ces vérifications jusqu'à ce que l'objectif sur les performances souhaitées, telles que la stabilité de gain en température par exemple, soit atteint.

Comme décrit par exemple dans les documents WO 2012/114836, US 2005/221764, US 6553084, la compensation des variations du gain, ou de la phase, ou de tout autre paramètre ou grandeur électrique, d'un équipement radiofréquence 10 peut également être réalisée à partir d'une commande numérique, ce qui permet d'améliorer la compétitivité de l'équipement grâce à des réductions de coût et de masse qui en résultent et de diminuer le temps de réglage de l'équipement. Cependant, contrairement à une commande analogique qui correspond à l'application d'une valeur, par exemple de tension, continue en entrée de l'équipement et à une variation continue de la grandeur électrique de l'équipement, par exemple du gain ou de la phase de l'équipement, une commande numérique est constituée d'une succession d'états numériques discontinus, appelés mots de commande numérique, enregistrés dans des tables de correspondance à différentes adresses d'une mémoire. Chaque mot de commande numérique enregistré correspond à une valeur de commande numérique à appliquer à l'équipement pour une valeur de consigne de gain imposée par l'utilisateur et pour une valeur de température mesurée sur l'équipement. Cependant, à chaque changement d'état, ces états discontinus induisent, sur la courbe de variation de la grandeur électrique, par exemple du gain, de l'équipement, des fluctuations parasites transitoires en amplitude et également en phase, ainsi que d'autres effets secondaires éventuels en fonction de la nature des grandeurs physiques commandées, qui peuvent être très rapides et qui, s'ils ne sont pas maîtrisés, peuvent perturber le débit et la qualité du trafic des télécommunications et induire un risque de décrochage des récepteurs de télécommunications dans la chaîne de communication incluant l'équipement. Pour résoudre ces problèmes, il est classique d'augmenter le nombre d'états enregistrés dans la mémoire et l'espace mémoire associé. Cependant, cette solution est limitée par la capacité de la mémoire disponible, nécessite l'utilisation de convertisseurs analogiques/numériques fonctionnant sur un nombre de bits numériques d'autant plus élevé que le nombre d'états augmente, ce qui ne permet pas de répondre à l'absence d'interruption de trafic en cas de changement de la valeur de la grandeur électrique, par exemple du gain ou de la phase, par télécommande.

Le but de l'invention est de remédier aux inconvénients des procédés de contrôle connus et de réaliser un procédé de compensation numérique des variations, en fonction de la température, d'une grandeur électrique d'un équipement de télécommunications radiofréquence spatial embarqué, qui ne nécessite pas d'augmenter la capacité de la mémoire, permet de limiter l'impact des fluctuations parasites transitoires, qui n'affecte pas les performances de transmission des données telles que le débit, la qualité du trafic et qui n'induit pas de risque de décrochage des récepteurs de télécommunications même en cas de modification de la valeur de consigne de la grandeur électrique.

Pour cela, l'invention concerne un procédé de compensation numérique des variations, en fonction de la température, d'une grandeur électrique d'un équipement de télécommunications radiofréquence spatial embarqué, l'équipement comportant N dispositifs élémentaires, où N est supérieur ou égal à un, la grandeur électrique de l'équipement devant être maintenue à une valeur de consigne prédéterminée, le procédé consistant :

- à mesurer la température de l'équipement à différents instants de mesure,
- à chaque instant de mesure, à interroger des tables de correspondance dans lesquelles sont enregistrés des mots de commande numérique à appliquer à l'équipement pour compenser les variations correspondantes de la grandeur électrique en fonction de la valeur de consigne prédéterminée et de différents états numériques de température enregistrés correspondant à différentes valeurs de température mesurées,

- lorsque la température mesurée est située entre deux états numériques de température enregistrés dans les tables de correspondance, à créer, des états numériques de température intermédiaires situés entre les deux états numériques de température enregistrés et à calculer, par interpolation, des mots de commande numérique correspondant aux états de température numérique intermédiaires créés,
- à sélectionner un mot de commande numérique correspondant à la température mesurée puis à délivrer, à l'équipement, la commande analogique correspondant au mot de commande numérique sélectionné.

Le procédé consiste en outre, entre deux mots de commande numérique enregistrés, à créer, par interpolation, des mots de commande numérique intermédiaires codés sur un nombre de bits supérieur au nombre de bits des mots de commande numérique enregistrés.

Avantageusement, selon un mode de réalisation, lorsque N est supérieur à un, à chaque changement d'état numérique de température, la commande analogique correspondant au mot de commande numérique sélectionné est délivrée à un seul des N dispositifs élémentaires de l'équipement, les N dispositifs élémentaires étant choisis séquentiellement à tour de rôle à chaque changement d'état numérique de température.

Alternativement, selon un autre mode de réalisation, à chaque changement d'état numérique de température, la commande analogique correspondant au mot de commande numérique sélectionné est répartie en N commandes analogiques élémentaires respectivement délivrées aux N dispositifs élémentaires de l'équipement, les N commandes analogiques élémentaires étant décalées temporellement les unes par rapport aux autres.

Avantageusement le procédé peut consister en outre, à appliquer un filtrage temporel linéaire à la tension de commande analogique.

D'autres particularités et avantages de l'invention apparaîtront clairement dans la suite de la description donnée à titre d'exemple purement illustratif et non limitatif, en référence aux dessins schématiques annexés qui représentent :

- figure 1 : un schéma synoptique d'un exemple de dispositif de compensation analogique des variations d'une grandeur électrique, par exemple du gain, d'un équipement de télécommunications radiofréquence en fonction de la température, selon l'art antérieur ;
- figure 2 : un schéma synoptique d'un exemple de dispositif de compensation numérique des variations d'une grandeur électrique, par exemple du gain d'un équipement de télécommunications radiofréquence en fonction de la température, selon l'art antérieur;
- figure 3a : un schéma d'un exemple de courbe de variation naturelle d'une grandeur électrique d'un équipement en fonction de la température, en l'absence de toute compensation, selon l'art antérieur ;
- figure 3b : un schéma d'un exemple de table de correspondance, pour une consigne de gain donnée, enregistrée dans une mémoire, selon l'art antérieur;
- figure 3c : un exemple de courbe de variation du gain d'un équipement compensé numériquement en température, selon l'art antérieur ;
- figure 3d : un exemple de courbe de variation de la tension de commande de l'équipement de la figure 2, selon l'art antérieur ;
- figure 4a : un synoptique illustrant les principales étapes d'un mode de réalisation du procédé de compensation, selon l'invention ;
- figure 4b: un tableau illustrant un exemple de compensation numérique des variations d'une grandeur électrique consistant, à partir des tables de correspondance, à créer des états de température intermédiaires afin de réduire l'amplitude et la phase des fluctuations d'une grandeur électrique d'un équipement, selon un mode de réalisation de l'invention ;
- figure 4c : un exemple de courbe de variation du gain d'un équipement compensé numériquement en température, selon l'exemple de compensation de la figure 4b ;
- figure 4d : un exemple de courbe illustrant des tensions de commande analogique pour les différents états numérisés de température de la figure 4b.

- figure 5a: un schéma illustrant un premier exemple de réalisation d'un dispositif de compensation numérique des variations d'une grandeur électrique, permettant de réduire l'amplitude et la phase des fluctuations de la grandeur électrique à chaque changement d'état numérique, selon un mode de réalisation de l'invention ;
- figure 5b : un schéma illustrant un premier exemple d'application des commandes numériques à l'équipement, selon le mode de réalisation de la figure 5a ;
- figure 5c : un schéma illustrant un deuxième exemple d'application des commandes numériques à l'équipement, selon le mode de réalisation de la figure 5a ;
- figure 6a : un tableau illustrant un autre exemple de compensation numérique des variations d'une grandeur électrique consistant, à partir des tables de correspondance, à créer des mots de commande intermédiaires afin de réduire l'amplitude et la phase des fluctuations d'une grandeur électrique d'un équipement, selon un autre mode de réalisation de l'invention ;
- figure 6b : un exemple de courbe de variation du gain d'un équipement compensé numériquement en température, selon l'exemple de compensation de la figure 6a ;
- figure 6c : un exemple de courbe illustrant des tensions de commande analogique pour les différents états numérisés de température de la figure 6a
- figure 7a : un schéma synoptique d'un exemple de dispositif de compensation numérique des variations du gain d'un équipement de télécommunications radiofréquence en fonction de la température comportant un dispositif de filtrage, selon un autre mode de réalisation de l'invention
- figure 7b : un exemple de courbe d'évolution d'une tension de commande après filtrage lors d'un changement d'état numérique de commande, selon le mode de réalisation de la figure 7a.

Le dispositif de compensation numérique des variations d'une grandeur électrique, par exemple du gain ou de la phase, d'un équipement de télécommunications radiofréquence en fonction de la température représenté sur la figure 2 comporte un équipement 10 dont une grandeur électrique varie en fonction de la température, un dispositif de mesure numérique 21 de la température de l'équipement, un dispositif de commande numérique 20 de l'équipement relié à une mémoire programmable 22 et un convertisseur numérique/analogique DAC 23 apte à convertir la commande numérique délivrée par le dispositif de commande numérique 20 en une commande analogique Vc appliquée à l'équipement 10. Dans cet exemple, la grandeur électrique variable en température est le gain de l'équipement et la commande est une tension, mais l'invention n'est pas limitée à ces grandeurs physiques. La mémoire programmable 22 peut par exemple être choisie parmi les mémoires de type PROM (en anglais : Programmable Read Only Memory) ou EPROM (en anglais : Erasable Read Only Memory) ou EEPROM (en anglais : Electrically Erasable Read Only Memory) ou peut être une mémoire associée ou incorporée dans une ASIC (en anglais : Application Specific Integrated Circuit), un micro-contrôleur ou un circuit logique programmable, ou un réseau logique programmable par exemple un FPGA (en anglais field-programmable gate array). L'équipement de télécommunications 10 peut comporter un ou plusieurs dispositifs élémentaires 11, 12 disposés en série et chaque dispositif élémentaire 11, 12 peut comporter une grandeur électrique, par exemple un gain, qui varie avec la température. Le dispositif de commande numérique 20 comporte une entrée destinée à recevoir une valeur de consigne imposée par un utilisateur et une entrée connectée au dispositif de mesure 21 de température. La valeur de consigne dépend de la grandeur électrique qui varie en température et peut par exemple être une valeur de consigne de gain si la grandeur électrique qui varie en température est le gain. La mémoire 22 contient des tables de correspondance donnant, pour une valeur de consigne imposée par un utilisateur, des mots de commande numérique correspondant à différentes valeurs de température. Les mots de commande numérique sont rangés à différentes adresses de la mémoire 22, chaque adresse dépendant de la température et de la valeur de consigne. A la réception de chaque mesure de température transmise par le dispositif de mesure 21, le dispositif de commande numérique 20 interroge une adresse 24 de la mémoire 22 correspondant à la température mesurée et à la valeur de consigne et la mémoire 22 lui communique en retour le mot de commande numérique 25 enregistré à cette adresse. A la réception du mot de commande numérique, le dispositif de commande numérique 20 le transmet au convertisseur numérique/analogique 23 qui convertit le mot de commande numérique en une commande analogique 27, par exemple une tension de commande Vc, qui est appliquée sur une entrée de commande de l'équipement 10. Si l'équipement 10 comporte plusieurs dispositifs élémentaires 12 identiques dont une grandeur électrique, par exemple le gain, doit être régulé en fonction de la température, par exemple plusieurs atténuateurs et/ou plusieurs amplificateurs reliés en série, la commande analogique 27 appliquée à l'entrée de commande de l'équipement 10 est ensuite appliquée simultanément en parallèle sur l'entrée de commande respective de chacun de ces dispositifs élémentaires dont la grandeur électrique doit être régulée.

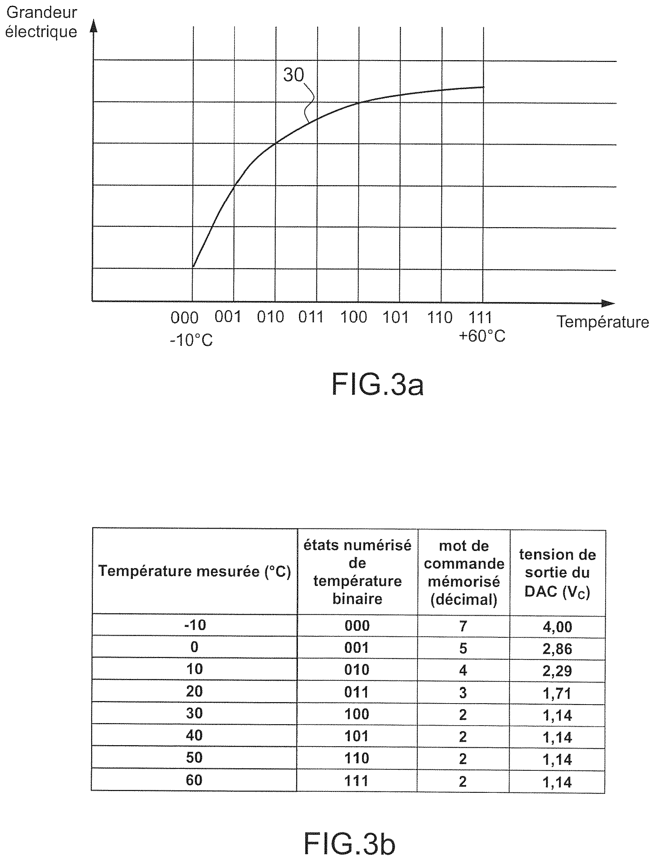

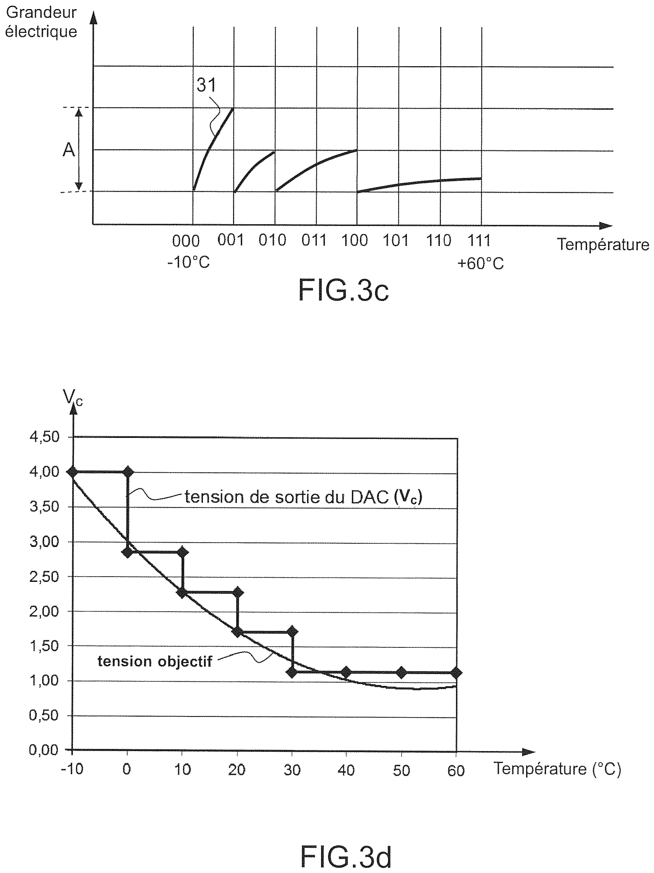

A titre d'exemple non limitatif, sur la figure 3a est illustré un exemple de courbe 30 de variation naturelle d'une grandeur électrique, par exemple le gain, d'un équipement en fonction de la température, les variations n'étant pas compensées. Pour compenser les variations de la grandeur électrique en fonction de la température, une valeur de consigne souhaitée est choisie par l'utilisateur. Des mesures de température sont régulièrement réalisées sur l'équipement et transmises au dispositif de commande numérique 20 qui recherche dans la mémoire 22, la table de correspondance qui correspond à la valeur de consigne choisie. Sur la figure 3b est représenté un exemple de table de correspondance qui peut être enregistrée dans la mémoire 22 pour une valeur de consigne donnée. Dans cet exemple, la valeur de consigne est une valeur de gain G, les valeurs de température enregistrées dans la table de correspondance sont indiquées en degrés centigrades dans la première colonne, les états numérisés de température codés en binaire sur i bits, où i est égal à trois dans cet exemple, sont indiqués dans la deuxième colonne, les mots de commande numérique mémorisés correspondant aux différentes valeurs de température sont indiqués en valeurs décimales dans la troisième colonne. Dans la quatrième colonne sont enregistrées les valeurs en volts, des tensions de sortie du convertisseur numérique/analogique DAC 23 correspondant aux différents mots de commande mémorisés. La mémoire 22 peut comporter un grand nombre de tables de correspondance différentes respectivement dédiées à des valeurs de consigne de gain différentes. Les différentes tables de correspondance comportent différents états numériques enregistrés, chaque état numérique associant, pour une valeur de consigne de gain G imposée par un utilisateur, et pour une valeur de température de l'équipement, un mot de commande numérique correspondant à une tension de commande analogique à appliquer à l'équipement pour compenser l'effet de la température sur la variation globale du gain de l'équipement. La précision de la compensation en température dépend du nombre d'états différents numérisés et enregistrés dans la mémoire. Lorsque la température mesurée est comprise entre deux états consécutifs numérisés et enregistrés dans la mémoire, l'état correspondant à la température mesurée n'étant pas enregistré dans la table de correspondance, le mot de commande sélectionné correspond, selon le choix, à l'état de température enregistré immédiatement inférieur ou immédiatement supérieur à cette température mesurée. Pour une consigne de gain donnée, la compensation du gain en température est alors incomplète et le gain varie en fonction de la température selon une courbe 31 en dent de scie comme représenté par exemple sur la figure 3c où les différentes températures successives sont représentées en abscisses et le gain en ordonnées. Par exemple pour une variation de température comprise entre -10° et +60°, une consigne de gain de G égale à 10dB et une table de correspondance comportant 8 états de température différents enregistrés, les 8 états différents correspondant à des températures espacées de 10°, le mot de commande 000 peut correspondre à la température -10°, le mot de commande 001 à la température 0°, le mot de commande 010 à la température +10°, ..., le mot de commande 111 à la température +60°. Entre deux états consécutifs enregistrés dans la table de correspondance, par exemple entre 0° et +10°, la commande de compensation du gain reste constante et égale à celle correspondant à 0°. Entre deux états consécutifs enregistrés, le gain n'est alors pas complètement compensé mais suit une courbe 30 de variation naturelle, croissante dans cet exemple, lorsque la température croît. La courbe 31 correspond à une commande numérique constante entre deux états consécutifs enregistrés dans la table de correspondance. A chaque fois que la température atteint une valeur correspondant à un état enregistré dans la table de correspondance, par exemple 001, ou 010, ou 100, la compensation en température peut être réalisée de manière exacte grâce au mot numérique de commande enregistré dans la table de correspondance à cette adresse et conformément à la consigne de gain. Ainsi, à chaque fois que la température correspond à un état enregistré, le gain prend la valeur correspondant à la consigne de gain, par exemple 10 dB (déciBells). Chaque changement d'état numérique de température enregistré, appelé transition, correspond donc à une variation d'amplitude brutale du gain de l'équipement correspondant à l'amplitude d'un signal transitoire. Par exemple, sur la figure 3c, la transition de l'état numérique de température enregistré 000 à l'état 001, correspond à une variation d'amplitude de valeur A. La figure 3d illustre un exemple de courbe de variation de la tension de commande de l'équipement délivré par le DAC 23 de la figure 2.

Dans le domaine des télécommunications, il est particulièrement important de réduire l'amplitude de variation du gain ou de la phase de l'équipement de télécommunications radiofréquence spatial embarqué à chaque changement d'état numérique afin de limiter l'apparition des fluctuations rapides transitoires qui engendrent des variations brutales du gain et de la phase des signaux de télécommunications, qui perturbent le trafic des données et qui peuvent faire décrocher les démodulateurs numériques des chaînes de transmission des données.

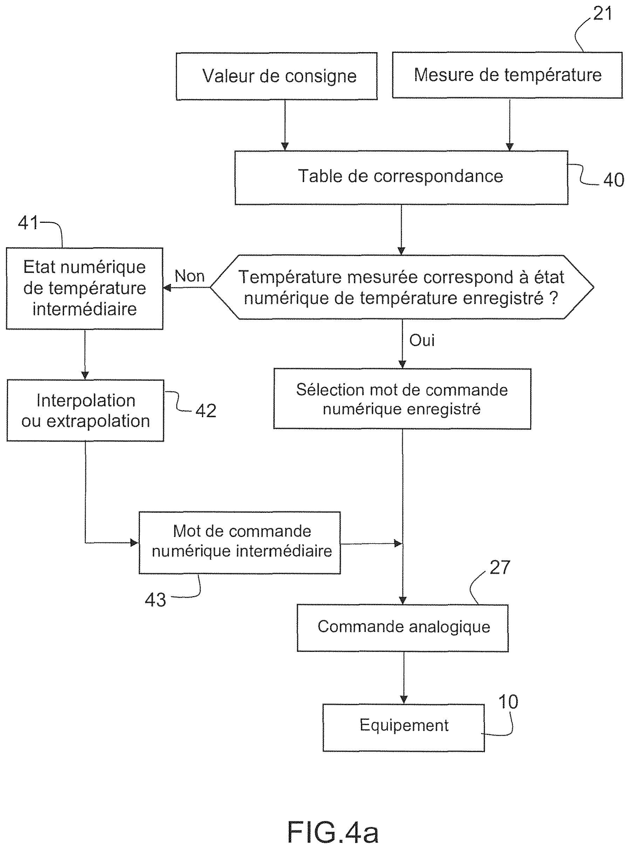

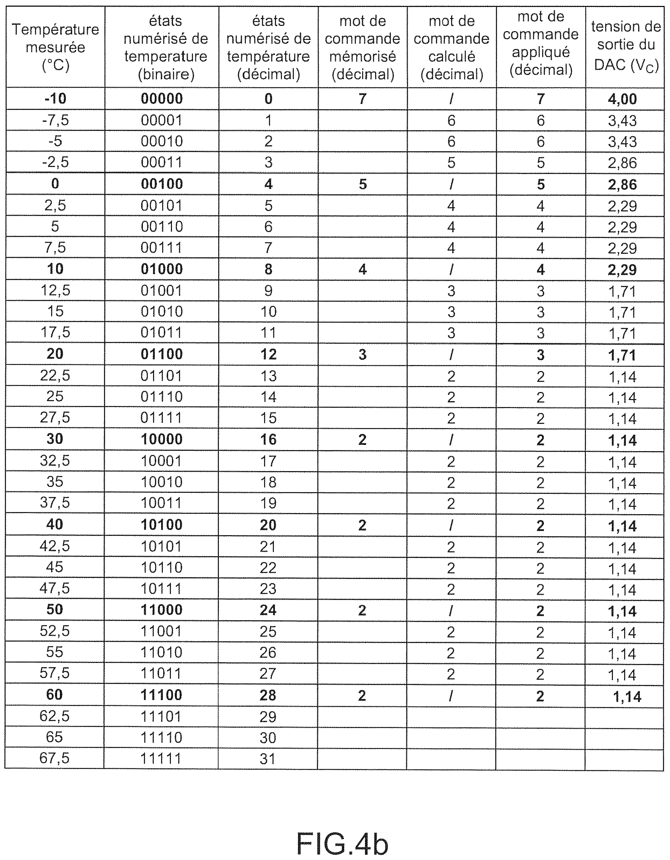

La suite de la description concerne le cas où l'équipement de télécommunications 10, intégré dans une chaine de transmission des données, comporte N dispositifs élémentaires 12a, 12b,..., 12c dont une grandeur électrique, par exemple le gain ou la phase, peut être commandée en fonction de la température pour compenser les variations des performances de l'ensemble de la chaine de transmission des données. Les N dispositifs élémentaires 12a, 12b,..., 12c peuvent être connectés en série ou en parallèle. Comme illustré sur le synoptique de la figure 4a, pour réduire l'amplitude de variation de la grandeur électrique, par exemple le gain ou la phase, de l'équipement de télécommunications 10, à chaque changement d'état numérique de température, sans augmenter le nombre de bits utilisé pour le codage des mots de commande en binaire, l'invention consiste, entre les différents états numériques de température enregistrés dans les tables de correspondance de la mémoire 22, à créer 41, dans le dispositif de commande numérique 20, des états numériques de température intermédiaires additionnels correspondant à des températures mesurées ayant des valeurs comprises dans le domaine de variation des températures mémorisées, et, le cas échéant, des états numériques de température intermédiaires additionnels correspondant à des températures mesurées 21 ayant des valeurs situées au-delà du domaine de variation des températures mémorisées, puis à calculer 42 par interpolation, ou respectivement par extrapolation, des mots de commande numériques additionnels 43 correspondant aux états numériques de température intermédiaires créés. Chaque mot de commande numérique additionnel est calculé, par interpolation ou par extrapolation, à partir d'au moins deux états numériques enregistrés dans une table de correspondance 40 de la mémoire 22, les deux états numériques enregistrés pouvant être consécutifs, c'est-à-dire correspondre à deux valeurs de température immédiatement supérieure et immédiatement inférieure à la température mesurée, ou non consécutifs. Tout type d'interpolation ou d'extrapolation peut être utilisé, par exemple linéaire ou de type plus complexe. Ainsi, à partir de l'exemple de table de correspondance de la figure 3b, dans laquelle le nombre de bits de codage binaire i pour chaque état numérique de température est égal à trois, il est possible de créer des états de température numériques additionnels en utilisant, pour chaque état numérique de température, un nombre de bits de codage binaire j supérieur à i, donc supérieur à trois dans cet exemple. Par exemple, si la valeur de j est choisie égale à cinq comme représenté sur la figure 4b, les états de température numérisés sur trois bits et enregistrés dans la mémoire 22 sont modifiés en états de température numérisés sur cinq bits, ce qui permet d'ajouter, entre deux états, k et k+1, de température $T_k$ et $T_{k+1}$ consécutifs, trois états numériques de température intermédiaires calculés et donc de multiplier par quatre le nombre d'états disponibles par rapport au nombre d'états de température mémorisés dans la mémoire 22. En particulier, sur l'exemple de la figure 4b, pour une température mesurée comprise entre $T_k$ = -10° et $T_{k+1}$ = 0° et correspondant respectivement aux deux états numériques mémorisés de température 00000 et 00100, le dispositif de commande numérique 20 calcule par interpolation/extrapolation des mots de commande intermédiaires additionnels qui sont appliqués pour des états de température intermédiaires Tint correspondant aux états numériques 00001, 00010, 00011. Dans cet exemple, une interpolation permet de calculer des mots de commande intermédiaires Mc(Tint) pour tous les états de température intermédiaires Tint compris entre deux états de température consécutifs $T_k$ et $T_{k+1}$ enregistrés dans la mémoire 22. Par exemple, dans le cas où l'interpolation est de type linéaire, le mot de commande intermédiaire Mc(Tint) calculé, en valeur décimale, correspondant à l'état de température intermédiaire Tint, numérisé en valeur décimale, peut être calculé par l'équation ci-dessous :

$$Mc(Tint) = Mc(T_k) + [Mc(T_{k+1}) - Mc(T_k)] * [ (Tint - T_k] / [T_{k+1} - T_k]$$

Ainsi, par exemple, lorsque Tint est l'état de température intermédiaire correspondant au mot numérique 00001, le mot de commande calculé correspondant Mc(00001)= 7 + [5 - 7] x [1 - 0] / [4 - 0] = 6,5.

Le mot de commande numérique devant être un nombre entier, selon l'invention, seule la partie entière du mot de commande calculé, égale à 6 dans cet exemple, est retenue comme mot de commande numérique interpolé pour la température numérique intermédiaire correspondant à la valeur binaire 00001.

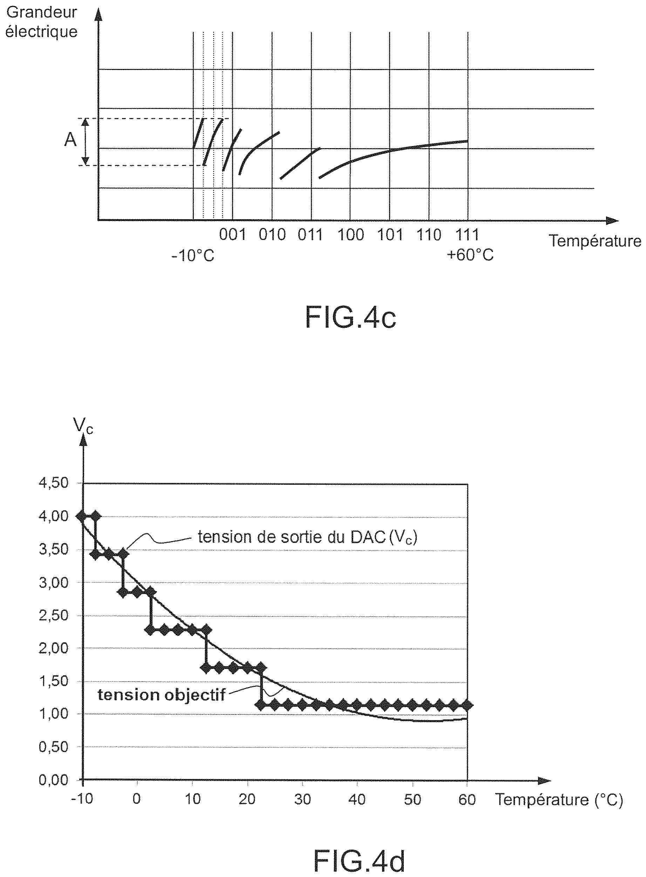

La figure 4c illustre un exemple de courbe de variation du gain d'un équipement de télécommunications obtenu après compensation numérique en température, conformément à ce mode de réalisation. Les tensions de commande analogique Vc en résultant en sortie du DAC 23 sont représentées sur la figure 4d pour les différents états numérisés de température.

En ajoutant, par interpolation linéaire, plusieurs états de température intermédiaires entre les différents états de température mémorisés, il est ainsi possible de compenser plus finement toute grandeur électrique, de l'équipement, par exemple le gain ou la phase, en fonction de la température et de réduire considérablement l'amplitude de variation de cette grandeur électrique de l'équipement, à chaque changement d'état numérique, sans augmenter l'espace mémoire comme le montre par exemple, la courbe typique de variation de gain en fonction de la température représentée sur la figure 4c. En effet, la courbe de gain représentée sur la figure 4c, montre que les transitoires et les variations A de gain sont plus faibles dans ce mode de réalisation de l'invention que sur la courbe de gain représentée sur la figure 3c correspondant à l'art antérieur, alors que l'espace mémoire utilisé dans ces deux réalisations est le même.

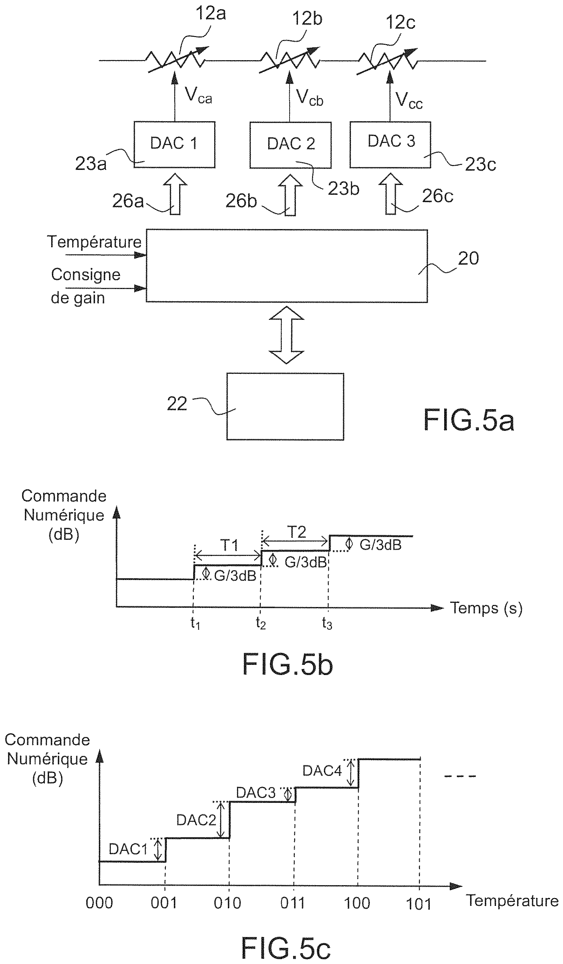

Conjointement à la création d'états de température numérique intermédiaires, l'invention peut comporter une étape additionnelle consistant à décomposer les éventuelles fluctuations transitoires du gain ou de la phase de l'équipement en plusieurs signaux transitoires élémentaires d'amplitudes plus faibles et répartis dans le temps. Pour cela, comme représenté sur la figure 5a dans le cas où N est égal à trois, au lieu d'appliquer une commande analogique globale 27 en entrée de l'équipement 10 pour réguler globalement le gain ou la phase de l'équipement, l'invention consiste à scinder la commande de compensation globale du gain ou de la phase de l'équipement en N commandes analogiques élémentaires Vca, Vcb,... Vcc différentes, indépendantes les unes des autres, d'amplitudes plus faibles et réparties dans le temps, les N commandes analogiques élémentaires étant respectivement appliquées en entrée des N dispositifs élémentaires 12a, 12b,..., 12c correspondants de l'équipement. Les N commandes analogiques élémentaires sont fournies par N convertisseurs numériques analogiques différents 23a, 23b, 23c respectivement connectés sur N sorties différentes du dispositif de commande numérique 20 et sont élaborées à partir de N commandes numériques élémentaires fournies par le dispositif de commande numérique 20.

Les N commandes élémentaires peuvent être élaborées par différentes méthodes.

Dans une première méthode illustrée sur la figure 5b, à chaque changement d'état numérique de température, la commande analogique correspondant au mot de commande numérique sélectionné est répartie en N commandes analogiques élémentaires respectivement délivrées aux N dispositifs élémentaires, les N commandes analogiques élémentaires étant décalées temporellement les unes par rapport aux autres. Pour cela, le dispositif de commande numérique 20 interroge la mémoire 22 pour obtenir le mot de commande numérique correspondant approximativement à une consigne de gain ayant une valeur réduite d'un facteur N par rapport à la consigne de gain globale fixée par l'utilisateur. Le mot de commande numérique ainsi obtenu est traité par le dispositif de commande numérique qui délivre alors N commandes numériques 26a, 26b, ..., 26c sur ses N sorties. Cependant, selon l'invention, les N commandes numériques élémentaires ne sont pas délivrées simultanément par le dispositif de commande numérique, mais séquentiellement. Pour cela, les N commandes numériques sont retardées les unes par rapport aux autres selon un séquencement prédéfini de façon à répartir dans le temps, les éventuelles fluctuations transitoires dues à chaque compensation du gain d'un dispositif élémentaire. Les N convertisseurs numériques analogiques DAC 23a, 23b, 23c, convertissent ensuite les N commandes numériques délivrées sur les N sorties du dispositif de commande numérique en N tensions de commande analogiques élémentaires respectivement dédiées à la commande du gain ou de la phase des N dispositifs élémentaires de l'équipement, chaque tension de commande analogique ayant une sensibilité réduite d'un facteur approximativement égal à 1/N par rapport à la tension analogique globale à appliquer à l'équipement. Sur l'exemple des figures 5a et 5b, N est égal à 3 et le mot de commande numérique issu de la mémoire 22 correspond à une consigne de gain, notée G/3, associée à chaque dispositif élémentaire. Les trois commandes numériques élémentaires 26a, 26b, 26c, correspondant aux trois consignes de gain associées à chaque dispositif élémentaire, sont délivrées sur les trois sorties du dispositif de commande 20 à des instants différents. La première commande numérique élémentaire est transmise au premier convertisseur numérique analogique 23a à l'instant $t_1$, puis après un premier retard T1, la deuxième commande numérique élémentaire est transmise au deuxième convertisseur numérique analogique 23b à l'instant $t_2$, enfin, après un second retard T2, la troisième commande numérique élémentaire est transmise au troisième convertisseur numérique analogique 23c à l'instant $t_3$.

Dans une deuxième méthode illustrée sur la figure 5c, à chaque changement d'état numérique de température, appelé aussi transition de température, le dispositif de commande numérique 20 n'élabore qu'une seule commande numérique qui est appliquée sur un seul convertisseur numérique analogique DAC pour commander un seul dispositif élémentaire de l'équipement à chaque changement d'état de température, le convertisseur numérique analogique DAC et le dispositif élémentaire correspondant commandés à chaque nouvelle transition de température, étant choisis successivement et cycliquement, les uns après les autres. Ainsi, à chaque transition de température, les commandes numériques 26a, 26b, 26c appliquées en entrée de chaque convertisseur numérique analogique DAC1 23a, DAC2 23b et DAC3 23c peuvent être différentes les unes des autres. Par exemple, lorsque le mot de température passe de la valeur 000 à 001, seul le premier DAC voit une commande numérique modifiée sur son entrée et le mot de commande dédié au DAC1 23a peut être modifié pour compenser les variations en température correspondantes. Lorsque le mot de température passe de la valeur 001 à 010, seul le deuxième DAC voit une commande numérique modifiée sur son entrée et le mot de commande dédié au DAC2 23b peut être modifié pour compenser les variations en température. Lorsque le mot de température passe de la valeur 010 à 011, seul le troisième DAC voit une commande numérique modifiée sur son entrée et le mot de commande dédié au DAC 23c peut être modifié pour compenser les variations en température. Puis à nouveau seul le DAC 23a voit une commande numérique modifiée sur son entrée entre 011 et 100, et ainsi de suite, ce qui permet de limiter le transitoire vu par l'utilisateur sur la chaîne radiofréquence complète. L'ordre d'application des différentes commandes numériques n'est pas limité à l'exemple décrit ci-dessus et peut être modifié en fonction des besoins. Toujours selon le même principe de n'avoir qu'un seul dispositif élémentaire rafraîchi pour chaque transition numérique de température, d'autres solutions peuvent être envisagées notamment en utilisant différemment les N dispositifs élémentaires. Tout ou partie de ces dispositifs élémentaires peuvent être utilisés pour réaliser la compensation en température, tout ou partie de ces dispositifs élémentaires peuvent être utilisés pour appliquer la consigne imposée par l'utilisateur, un même dispositif élémentaire pouvant être utilisé uniquement pour la compensation en température ou au contraire uniquement pour la consigne imposée par l'utilisateur ou à la fois pour la compensation en température et la consigne de l'utilisateur.

Pour réduire l'amplitude de variation du gain d'un équipement à chaque changement d'état numérique sans augmenter l'espace mémoire nécessaire, conjointement à la création d'états numériques de température intermédiaires, l'invention peut consister en outre, à prévoir un nombre d'états de commande numérique 26 en entrée du DAC 23, plus grand que le nombre d'états de commande mémorisés dans la mémoire 22. Dans ce cas, le dispositif de commande 20 doit également créer par calcul des mots de commande intermédiaires $Mcint(T_p)$, correspondant aux états de commande intermédiaires à ajouter entre deux états de commande numériques consécutifs correspondants aux mots de commande $Mc(T_{p-1})$ et $Mc(T_{p+1})$ mémorisés et enregistrés dans les tables de la mémoire 22, les mots de commande $Mc(T_{p-1})$ et $Mc(T_{p+1})$ étant respectivement associés à deux valeurs de température enregistrées immédiatement inférieure $T_{p-1}$ et immédiatement supérieure $T_{p+1}$ à la température intermédiaire mesurée $T_{pint}$. Pour cela, chaque mot de commande intermédiaire est calculé par le dispositif de commande 20, par interpolation, ou par extrapolation, à partir des mots de commande $Mc(T_{p-1})$ et $Mc(T_{p+1})$ mémorisés. Tout type d'interpolation, ou extrapolation peut être utilisé, tel que par exemple une interpolation linéaire ou une interpolation de type non linéaire plus complexe.

Par exemple, selon ce mode de réalisation, les mots de commande mémorisés peuvent être codés sur n bits et les mots de commande calculés et appliqués en entrée du DAC 23 peuvent être codés sur m bits, avec m>n. Par exemple, les mots de température mémorisés peuvent être codés sur i bits et les mots de température calculés dans le dispositif de commande 20 peuvent être codés sur j bits, avec j>i.

$Mcint(T_{pint})$ est le mot de commande intermédiaire de m bits calculé par interpolation/extrapolation pour le mot de température intermédiaire mesuré $T_{pint}$ codé sur j bits.

L'interpolation/extrapolation consiste alors à calculer $Mc(T_p)$ en fonction des variables connues $Mc(T_{p-1})$, $Mc(T_{p+1})$ $T_{pint}$, $T_{p-1}$, $T_{p+1}$. Une méthode de calcul possible peut consister, par exemple, à utiliser une interpolation linéaire, mais d'autres types d'interpolation peuvent également être utilisés. Dans le cas de l'utilisation d'une interpolation linéaire, $Mcint(T_{pint})$ peut être calculé comme suit :

$$Mcint(T_{pint}) = 2^{m-n} \times [\ Mc(T_{p-1}) + (((Mc(T_{p+1}) - Mc(T_{p-1})) \times (T_{pint} - T_{p-1}) / (T_{p+1} - T_{p-1}))\ ]$$

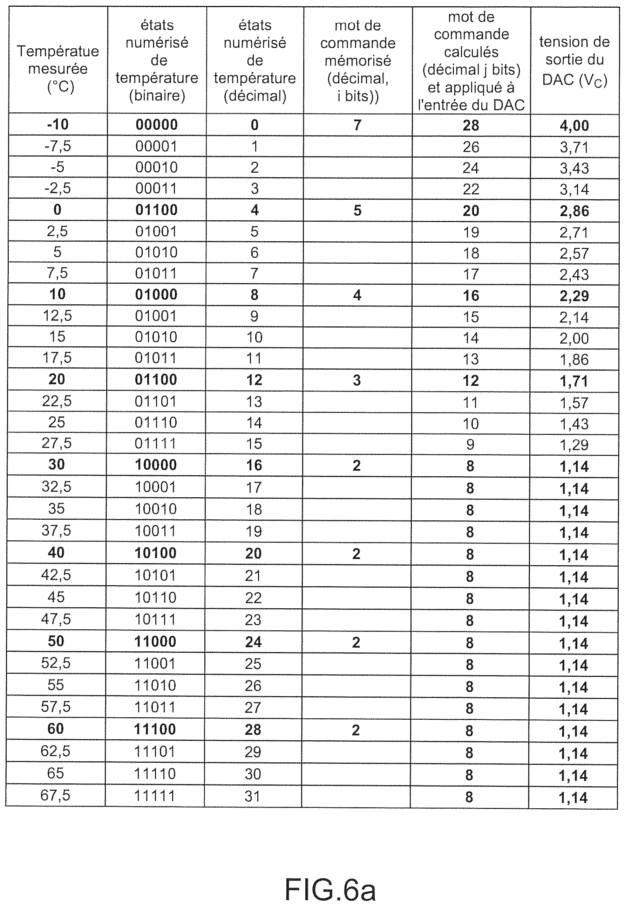

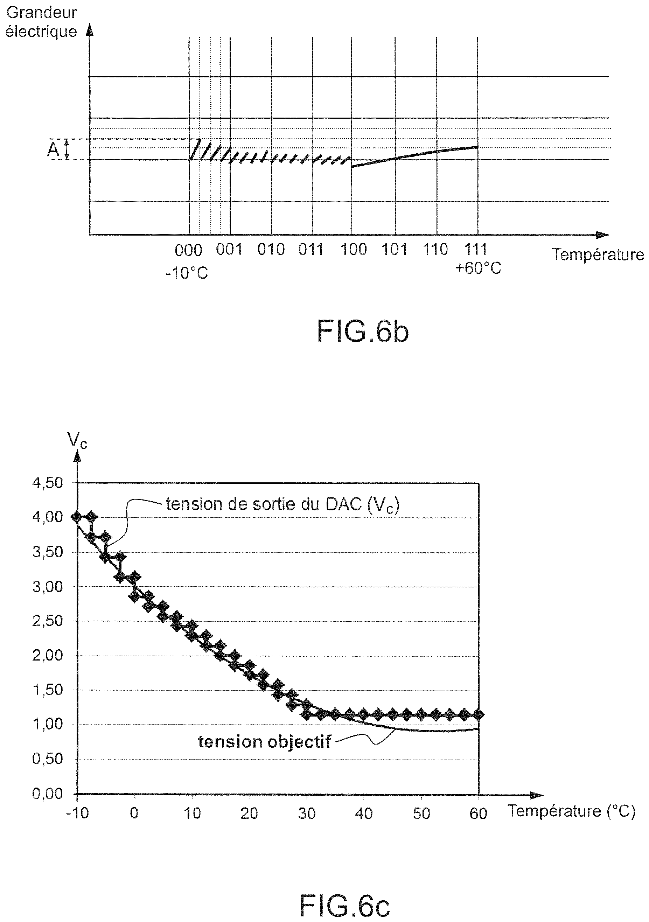

Les figures 6a, 6b, 6c, illustrent un exemple conforme à ce troisième mode de réalisation de l'invention, dans lequel i=3 et j =i+2=5 et n=3 et m=n+2=5. En appliquant la formule de calcul indiqué ci-dessus à l'exemple de la figure 3b, on obtient le tableau de la figure 6a. Par exemple :

$$Mcint(00001) = 2^2 \times [\ 7 + ((5\text{-}7) \times (1 - 0) / (4 - 0))] = 26$$

$$Mcint(01111) = 2^2 \times [\ 3 + ((2\text{-}3) \times (15 - 12) / (16 - 12))] = 9$$

En ajoutant, par interpolation linéaire, plusieurs états intermédiaires entre les différents états de température mémorisés et également entre les différents états de commande mémorisés, ce qui consiste à interpoler sur un nombre de bits de commande supérieur au nombre de bit de commande mémorisé, il est ainsi possible de compenser plus finement le gain de l'équipement en fonction de la température et de réduire l'amplitude de variation du gain de l'équipement à chaque changement d'état numérique de température comme le montre l'exemple de la figure 6b. La figure 6c représente une courbe typique de variation de tension de commande correspondante, en fonction de la température. La comparaison des figures 6b, 4c et 3c montre l'avantage apporté par ce troisième mode de réalisation de l'invention qui permet d'obtenir des variations de gain plus faibles et donc de diminuer l'amplitudes A des signaux transitoires sans pour autant avoir augmenté l'espace de la mémoire 22.

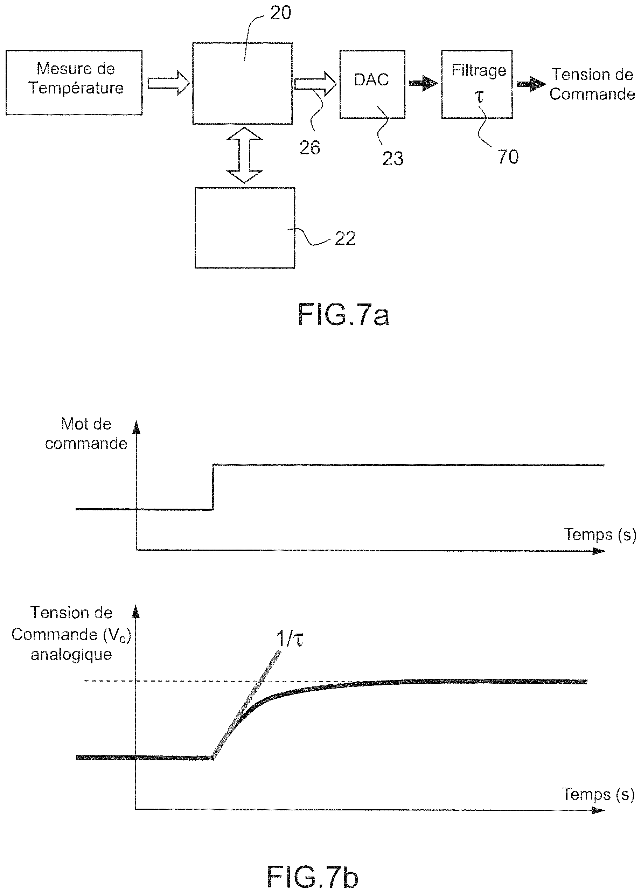

Enfin, l'invention peut comporter une étape consistant, en sortie du convertisseur numérique/analogique 23, à introduire un dispositif de filtrage temporel linéaire analogique 70 ayant une constante de temps τ, qui filtre dans un rapport 1/τ, la tension de commande Vc délivrée par le convertisseur numérique/analogique, comme représenté sur les exemples des figures 7a et 7b. Le dispositif de filtrage 70 de type passe-bas, permet à chaque changement d'état, de lisser la variation de la tension de commande analogique Vc qui en résulte et de limiter et ralentir les fluctuations d'amplitude et de phase parasites au niveau du gain de l'équipement pour qu'elles soient négligeables sur la durée d'un bit de données des signaux de télécommunications. La valeur de la constante de temps τ du filtrage résulte d'un compromis. La constante de temps τ est en effet optimisée pour être d'une part suffisamment longue pour assurer l'innocuité des fluctuations transitoires parasites par rapport aux signaux de télécommunications et éviter tout risque d'interruption de trafic en cas de compensation numérique de gain et également en cas de changement de gain par télécommande, et d'autre part, suffisamment courte pour pouvoir être implémentée facilement et ne pas contraindre l'utilisation de l'équipement lors des tests ou de son fonctionnement opérationnel. La constante de temps τ dépend du type de modulation utilisé pour la transmission de données de communication mais est déterminée de façon que la phase des fluctuations parasites tourne d'un angle négligeable pendant la durée d'un bit ou d'un symbole. De manière optimale, le filtrage peut être dimensionné pour avoir une variation de phase négligeable lorsque le débit des télécommunications est très lent, par exemple inférieur ou égal à 64 Kbits/seconde, ce qui correspond par exemple au cas d'une modulation robuste de type QPSK ou BPSK très peu sensible aux variations de phase. Le filtrage peut également être dimensionné pour des cas de modulation plus efficaces de type 8PSK et plus, qui sont plus sensibles aux variations de phase, mais pour lesquels le débit des données sont actuellement de l'ordre de 8Mbits/seconde minimum. A titre d'exemple non limitatif, pour une modulation de type BPSK dans laquelle un symbole correspond à un bit, une variation de phase parasite inférieure à 0.1° sur un symbole, pour un débit de 6Kbits/seconde qui correspond à une période de 170μs, et un signal transitoire de 5°, il faut typiquement une constante de temps τ égale à 8ms. Le dispositif de filtrage peut être utilisé seul ou en combinaison avec le premier et/ou le deuxième et le troisième mode de réalisation de l'invention.

Bien que l'invention ait été décrite en liaison avec des modes de réalisation particuliers, il est bien évident qu'elle n'y est nullement limitée et qu'elle comprend tous les équivalents techniques des moyens décrits ainsi que leurs combinaisons si celles-ci entrent dans le cadre de l'invention, qui est définie dans les revendications.

**Revendications**

**1.** Procédé de compensation numérique des variations, en fonction de la température, d'une grandeur électrique d'un équipement de télécommunications radiofréquence spatial embarqué, l'équipement comportant N dispositifs élémentaires (12a, 12b,..., 12c), où N est supérieur ou égal à un, la grandeur électrique de l'équipement devant être maintenue à une valeur de consigne prédéterminée, le procédé consistant :

- à mesurer la température (21) de l'équipement (10) à différents instants de mesure,
- à chaque instant de mesure, à interroger des tables de correspondance (40) dans lesquelles sont enregistrés des mots de commande numérique à appliquer à l'équipement (10) pour compenser des variations correspondantes de la grandeur électrique en fonction de la valeur de consigne prédéterminée et de différents états numériques de température enregistrés correspondant à différentes valeurs de température mesurées,
- lorsque la température mesurée est située entre deux états numériques de température enregistrés dans les tables de correspondance, à créer (41) des états numériques de température intermédiaires situés entre les deux états numériques de température enregistrés et à calculer, par interpolation (42), des mots de commande numérique (43) correspondant aux états de température numérique intermédiaires créés,
- à sélectionner un mot de commande numérique correspondant à la température mesurée puis à délivrer, à l'équipement (10), la commande analogique (27) correspondant au mot de commande numérique sélectionné,

le procédé étant **caractérisé en ce qu'**il consiste en outre, entre deux mots de commande numérique enregistrés, à créer, par interpolation, des mots de commande numérique intermédiaires codés sur un nombre de bits supérieur au nombre de bits des mots de commande numérique enregistrés.

**2.** Procédé selon la revendication 1, **caractérisé en ce que**, lorsque N est supérieur à un, à chaque changement d'état numérique de température, la commande analogique (27) correspondant au mot de commande numérique sélectionné est délivrée à un seul des N dispositifs élémentaires (12a, 12b,..., 12c) de l'équipement (10), les N dispositifs élémentaires étant choisis séquentiellement à tour de rôle à chaque changement d'état numérique de température.

**3.** Procédé selon la revendication 1, **caractérisé en ce que**, à chaque changement d'état numérique de température, la commande analogique (27) correspondant au mot de commande numérique sélectionné est répartie en N commandes analogiques élémentaires respectivement délivrées aux N dispositifs élémentaires (12a, 12b,..., 12c) de l'équipement (10), les N commandes analogiques élémentaires étant décalées temporellement les unes par rapport aux autres.

**4.** Procédé selon l'une des revendications 1à 3, **caractérisé en ce qu'**il consiste en outre, à appliquer un filtrage temporel linéaire (70) à la tension de commande analogique.

**Patentansprüche**

**1.** Verfahren zur digitalen Kompensation von Variationen, abhängig von der Temperatur, einer elektrischen Größe einer Bord-Weltraumfunktelekommunikationsausrüstung, wobei die Ausrüstung N Elementarvorrichtungen (12a, 12b,..., 12c) beinhaltet, wobei N größer oder gleich eins ist, wobei die elektrische Größe der Ausrüstung auf einem vorbestimmten Sollwert gehalten werden soll, wobei das Verfahren aus folgenden Schritten besteht:

- Messen der Temperatur (21) der Ausrüstung (10) zu unterschiedlichen Messzeitpunkten,
- zu jedem Messzeitpunkt, Abfragen der Entsprechungstabellen (40), in welchen numerische Steuerworte gespeichert sind, die auf die Ausrüstung(10) anzuwenden sind, um entsprechende Variationen der elektrischen Größe abhängig vom vorbestimmten Sollwert und von unterschiedlichen gespeicherten, numerischen Temperaturwerten zu kompensieren, welche unterschiedlichen gemessenen Temperaturwerten entsprechen,
- wenn die gemessene Temperatur zwischen zwei in den Entsprechungstabellen gespeicherten, numerischen Temperaturwerten liegt, Erstellen (41) von numerischen Zwischentemperaturzuständen, welche zwischen den gespeicherten, numerischen Temperaturwerten liegen und Berechnen, durch Interpolation (42), von numerischen Steuerworten (43), welche den erstellten numerischen Zwischentemperaturzuständen entsprechen,
- Auswählen eines numerischen Steuerwortes, welches der gemessenen Temperatur entspricht und Abgeben, an die Ausrüstung (10), des Analogbefehls (27), welcher dem ausgewählten numerischen Steuerwort entspricht, wobei das Verfahren **dadurch gekennzeichnet ist, dass** es zudem darin besteht, zwischen zwei gespeicherten, numerischen Steuerworten durch Interpolation numerische Zwischensteuerworte zu erstellen, die mit einer Bitzahl codiert werden, welche größer ist als die Bitzahl der gespeicherten, numerischen Steuerworte.

2. Verfahren nach Anspruch 1, **dadurch gekennzeichnet, dass** wenn N größer als eins ist, bei jeder Änderung des numerischen Temperaturzustandes der dem ausgewählten numerischen Steuerwort entsprechende Analogbefehl (27) an nur eine der N Elementarvorrichtungen (12a, 12b,..., 12c) der Ausrüstung (10) abgegeben wird, wobei die N Elementarvorrichtungen sequenziell im Turnus bei jeder Änderung des numerischen Temperaturzustandes gewählt werden.

3. Verfahren nach Anspruch 1, **dadurch gekennzeichnet, dass** bei jeder Änderung des numerischen Temperaturzustandes der dem ausgewählten numerischen Steuerwort entsprechende Analogbefehl (27) in N elementare Analogbefehle aufgeteilt wird, welche jeweils an die N Elementarvorrichtungen (12a, 12b,..., 12c) der Ausrüstung (10) abgegeben werden, wobei die N elementaren Analogbefehle zeitlich voneinander versetzt sind.

4. Verfahren nach einem der Ansprüche 1 bis 3, **dadurch gekennzeichnet, dass** es zudem darin besteht, eine lineare zeitliche Filterung (70) auf die analoge Steuerspannung anzuwenden.

## Claims

1. Method for digitally compensating variations, as a function of temperature, of an electrical quantity of an embedded space radiofrequency telecommunications equipment item, the equipment item comprising N individual devices (12a, 12b, ..., 12c), where N is greater than or equal to one, the electrical quantity of the equipment item having to be maintained at a predetermined setpoint value, the method consisting:

   - in measuring the temperature (21) of the equipment item (10) at different measurement instants,
   - at each measurement instant, in interrogating look-up tables (40), in which digital control words are stored that are to be applied to the equipment item (10) to compensate for corresponding variations of the electrical variable as a function of the predetermined setpoint value and different registered digital temperature states corresponding to different measured temperature values,
   - when the measured temperature is situated between two digital temperature states stored in the look-up tables, in creating (41) intermediate digital temperature states situated between the two stored digital temperature states and in computing, by interpolation (42), digital control words (43) corresponding to the intermediate digital temperature states created,
   - in selecting a digital control word corresponding to the measured temperature then in delivering, to the equipment item (10), the analogue control (27) corresponding to the selected digital control word,

   the method being **characterized in that** it further consists, between two stored digital control words, in creating, by interpolation, intermediate digital control words encoded using a number of bits that is higher than the number of stored digital control words.

2. Method according to Claim 1, **characterized in that**, when N is greater than one, on each change of digital temperature state, the analogue control (27) corresponding to the selected digital control word is delivered to just one of the N individual devices (12a, 12b, ..., 12c) of the equipment item (10), the N individual devices being chosen sequentially in turn on each change of digital temperature state.

3. Method according to Claim 1, in which, on each change of digital temperature state, the analogue control (27) corresponding to the selected digital control word is divided up into N individual analogue controls respectively delivered to the N individual devices (12a, 12b, ..., 12c) of the equipment item (10), the N individual analogue controls being staggered in time relative to one another.

4. Method according to one of Claims 1 to 3, **characterized in that** it further consists in applying a linear temporal filtering (70) to the analogue control voltage.

FIG.1

FIG.2

Grandeur
électrique

000 001 010 011 100 101 110 111   Température
-10°C                          +60°C

## FIG.3a

| Température mesurée (°C) | états numérisé de température binaire | mot de commande mémorisé (décimal) | tension de sortie du DAC ($V_C$) |
|---|---|---|---|
| -10 | 000 | 7 | 4,00 |
| 0 | 001 | 5 | 2,86 |
| 10 | 010 | 4 | 2,29 |
| 20 | 011 | 3 | 1,71 |
| 30 | 100 | 2 | 1,14 |
| 40 | 101 | 2 | 1,14 |
| 50 | 110 | 2 | 1,14 |
| 60 | 111 | 2 | 1,14 |

## FIG.3b

Grandeur
électrique

A

31

000 001 010 011 100 101 110 111
-10°C +60°C

Température

FIG.3c

$V_c$

4,50
4,00
3,50
3,00
2,50
2,00
1,50
1,00
0,50
0,00

tension de sortie du DAC ($V_c$)

tension objectif

-10 0 10 20 30 40 50 60 Température (°C)

FIG.3d

21

Valeur de consigne    Mesure de température

Table de correspondance    40

41

Etat numérique de température intermédiaire    Non    Température mesurée correspond à état numérique de température enregistré ?

Oui

Interpolation ou extrapolation    42    Sélection mot de commande numérique enregistré

Mot de commande numérique intermédiaire

43

27

Commande analogique

10

Equipement

FIG.4a

| Température mesurée (°C) | états numérisé de temperature (binaire) | états numérisé de température (décimal) | mot de commande mémorisé (décimal) | mot de commande calculé (décimal) | mot de commande appliqué (décimal) | tension de sortie du DAC (V_C) |
|---|---|---|---|---|---|---|
| **-10** | **00000** | **0** | **7** | / | **7** | **4,00** |
| -7,5 | 00001 | 1 | | 6 | 6 | 3,43 |
| -5 | 00010 | 2 | | 6 | 6 | 3,43 |
| -2,5 | 00011 | 3 | | 5 | 5 | 2,86 |
| **0** | **00100** | **4** | **5** | / | **5** | **2,86** |
| 2,5 | 00101 | 5 | | 4 | 4 | 2,29 |
| 5 | 00110 | 6 | | 4 | 4 | 2,29 |
| 7,5 | 00111 | 7 | | 4 | 4 | 2,29 |
| **10** | **01000** | **8** | **4** | / | **4** | **2,29** |
| 12,5 | 01001 | 9 | | 3 | 3 | 1,71 |
| 15 | 01010 | 10 | | 3 | 3 | 1,71 |
| 17,5 | 01011 | 11 | | 3 | 3 | 1,71 |
| **20** | **01100** | **12** | **3** | / | **3** | **1,71** |
| 22,5 | 01101 | 13 | | 2 | 2 | 1,14 |
| 25 | 01110 | 14 | | 2 | 2 | 1,14 |
| 27,5 | 01111 | 15 | | 2 | 2 | 1,14 |
| **30** | **10000** | **16** | **2** | / | **2** | **1,14** |
| 32,5 | 10001 | 17 | | 2 | 2 | 1,14 |
| 35 | 10010 | 18 | | 2 | 2 | 1,14 |
| 37,5 | 10011 | 19 | | 2 | 2 | 1,14 |
| **40** | **10100** | **20** | **2** | / | **2** | **1,14** |
| 42,5 | 10101 | 21 | | 2 | 2 | 1,14 |
| 45 | 10110 | 22 | | 2 | 2 | 1,14 |
| 47,5 | 10111 | 23 | | 2 | 2 | 1,14 |
| **50** | **11000** | **24** | **2** | / | **2** | **1,14** |
| 52,5 | 11001 | 25 | | 2 | 2 | 1,14 |
| 55 | 11010 | 26 | | 2 | 2 | 1,14 |
| 57,5 | 11011 | 27 | | 2 | 2 | 1,14 |
| **60** | **11100** | **28** | **2** | / | **2** | **1,14** |
| 62,5 | 11101 | 29 | | | | |
| 65 | 11110 | 30 | | | | |
| 67,5 | 11111 | 31 | | | | |

# FIG.4b

FIG.4c

FIG.4d

12a    12b    12c

$V_{ca}$    $V_{cb}$    $V_{cc}$

| DAC 1 | DAC 2 | DAC 3 |

23a    26a    26b    23b    26c    23c

Température

Consigne
de gain

20

22

FIG.5a

Commande
Numérique
(dB)

T1    T2

G/3dB

G/3dB

G/3dB

Temps (s)

$t_1$    $t_2$    $t_3$

FIG.5b

Commande
Numérique
(dB)

DAC4

DAC3

DAC2

DAC1

000    001    010    011    100    101    Température

FIG.5c

| Températue mesurée (°C) | états numérisé de température (binaire) | états numérisé de température (décimal) | mot de commande mémorisé (décimal, i bits)) | mot de commande calculés (décimal j bits) et appliqué à l'entrée du DAC | tension de sortie du DAC ($V_C$) |
|---|---|---|---|---|---|
| -10 | 00000 | 0 | 7 | 28 | 4,00 |
| -7,5 | 00001 | 1 | | 26 | 3,71 |
| -5 | 00010 | 2 | | 24 | 3,43 |
| -2,5 | 00011 | 3 | | 22 | 3,14 |
| 0 | 01100 | 4 | 5 | 20 | 2,86 |
| 2,5 | 01001 | 5 | | 19 | 2,71 |
| 5 | 01010 | 6 | | 18 | 2,57 |
| 7,5 | 01011 | 7 | | 17 | 2,43 |
| 10 | 01000 | 8 | 4 | 16 | 2,29 |
| 12,5 | 01001 | 9 | | 15 | 2,14 |
| 15 | 01010 | 10 | | 14 | 2,00 |
| 17,5 | 01011 | 11 | | 13 | 1,86 |
| 20 | 01100 | 12 | 3 | 12 | 1,71 |
| 22,5 | 01101 | 13 | | 11 | 1,57 |
| 25 | 01110 | 14 | | 10 | 1,43 |
| 27,5 | 01111 | 15 | | 9 | 1,29 |
| 30 | 10000 | 16 | 2 | 8 | 1,14 |
| 32,5 | 10001 | 17 | | 8 | 1,14 |
| 35 | 10010 | 18 | | 8 | 1,14 |
| 37,5 | 10011 | 19 | | 8 | 1,14 |
| 40 | 10100 | 20 | 2 | 8 | 1,14 |
| 42,5 | 10101 | 21 | | 8 | 1,14 |
| 45 | 10110 | 22 | | 8 | 1,14 |
| 47,5 | 10111 | 23 | | 8 | 1,14 |
| 50 | 11000 | 24 | 2 | 8 | 1,14 |
| 52,5 | 11001 | 25 | | 8 | 1,14 |
| 55 | 11010 | 26 | | 8 | 1,14 |
| 57,5 | 11011 | 27 | | 8 | 1,14 |
| 60 | 11100 | 28 | 2 | 8 | 1,14 |
| 62,5 | 11101 | 29 | | 8 | 1,14 |
| 65 | 11110 | 30 | | 8 | 1,14 |
| 67,5 | 11111 | 31 | | 8 | 1,14 |

# FIG.6a

FIG.6b

FIG.6c

FIG.7a

FIG.7b

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2012114836 A
- US 2005221764 A
- US 6553084 B